# EUROPEAN PATENT APPLICATION

(11) **EP 2 063 573 A1**
(43) Date of publication of application: **27.05.2009**
(21) Application number: 08700104.6
(22) Date of filing: 10.01.2008
(51) Int. Cl.: H04L 12/44

(54) **TRANSMISSION METHOD, SYSTEM AND APPARATUS OF OVERHEAD INFORMATION**

(30) Priority: 16.01.2007 CN 200710000244
(71) Applicant: Huawei Technologies Co., Ltd., Shenzhen, Guangdong Province 518129 (CN)
(72) Inventor: JIANG, Zhangzhen, Shenzhen Guangdong 518129 (CN); ZHONG, Qiwen, Shenzhen Guangdong 518129 (CN)
(74) Representative: Körber, Martin Hans
(86) International application number: PCT/CN2008/070080
(87) International publication number: WO 2008/086751

(57) **Abstract**

A method for sending overhead information includes: encoding customer information into a 64B/66B customer information code block; encoding configured overhead information into a 64B/66B code block, and marking the code block as an overhead code block; and sending the customer information code block and the overhead code block, where M of every N sent code blocks are overhead code blocks (M and N are positive integers and M is smaller than N). A method for receiving overhead information includes: receiving the 64B/66B code block; identifying the overhead code block according to an identifier of the overhead code block and extracting overhead information from the overhead code block; and decoding the customer information code blocks other than the overhead code blocks and obtaining the customer information. Through the foregoing methods, fixed bandwidth of the overhead information is ensured, and the OAM information transmission performance is improved.

## Description

### FIELD OF THE INVENTION

The present invention relates to the block coding technology in communication transmission, and in particular, to a method, system, and device for transmitting overhead information.

### BACKGROUND

In a data communication network, block coding is generally used to determine the border of data processing, namely, the border of the bytes required for CPU processing, and differentiate the user load information from the control information. For example, the frame structures of a PDH signal, ATM signal, and packet-switching packets count as block frames; the frame of the E1 signal is a 32-byte block frame composed of 1 row and 32 columns, and an ATM signal is a block frame composed of 53 bytes.

The 64B/66B is a block coding mechanism widely applied to the high-speed data transmission process. The objectives are to determine the border of the data block, and provide control codes in the data stream. Currently, the 64B/66B is primarily applied in the 10G Ethernet, and is also applicable to the 100G Ethernet.

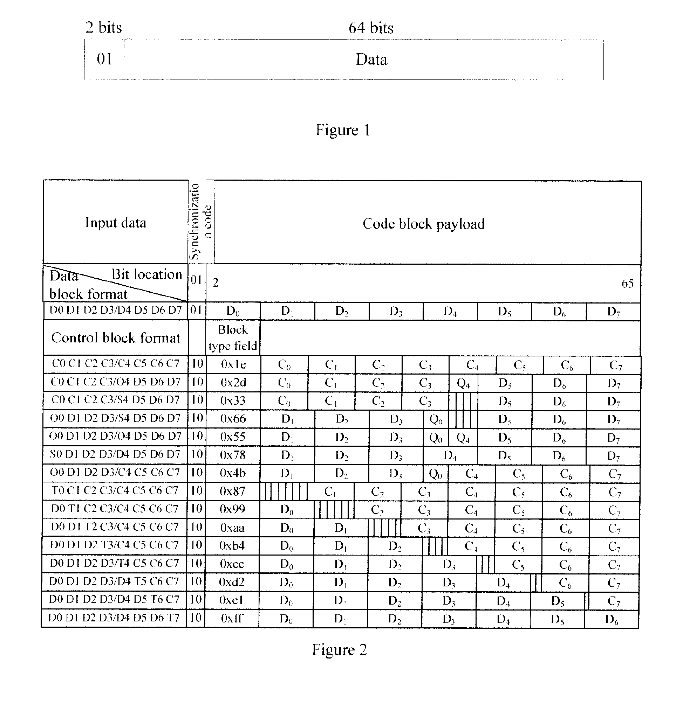

Figure 1 shows a 64B/66B code block. It is evident that the code block is composed of a 2-bit synchronization code and 64-bit control data. Figure 2 shows a coding mode of the 64B/66B applied in the 10G Ethernet in the prior art. As shown in Figure 2, the 2-bit synchronization code of the 64B/66B code block is "01" or "10". "01" means that the 64 bits subsequent to the 2-bit synchronization code are 8 data bytes; and " 10" means that the subsequent 64 bits are decided by the 8-bit data next to the 2-bit synchronization code. The whole coding process of the 64B/66B is: using the 66-bit data to represent the 64-bit user information and 8-bit user control information.

However, in the high-speed data transmission system with a rate such as 10 Gbps or even 100 Gbps, it is necessary to implement performance monitoring for the physical-layer information and transfer the fault information in the case of fault. An optional solution is to insert OAM information in the coding process for providing performance statistics and fault notification on the physical layer. When the OAM information on the physical layer is transmitted in the current high-speed data communication system, the physical-layer coding efficiency is reduced, the OAM information bandwidth is instable, and the detection functions implemented by the OAM information are limited.

### SUMMARY

Accordingly, a method for transmitting overhead information is provided in an embodiment of the present invention to improve the transmission performance of OAM information on the physical layer.

An overhead information transmission system and device are also provided in an embodiment of the present invention to improve the transmission performance of OAM information on the physical layer.

In order to fulfill the foregoing objectives, the following technical solution is applied.

A method for sending overhead information includes:
encoding customer information composed of user information and user control information into a 64B/66B customer information code block;
encoding configured overhead information into a 64B/66B code block, and marking the code block as an overhead code block; and
sending the customer information code block and the overhead code block, where M of every N sent code blocks are overhead code blocks (M and N are positive integers and M is smaller than N).

An overhead information receiving method includes:
receiving 64B/66B code blocks;
identifying an overhead code block according to an identifier of the overhead code block, and extracting overhead information from the overhead code block; and
decoding customer information code blocks other than the overhead code blocks to obtain customer information.

An overhead information transmission system includes:
a sending device, adapted to: encode the customer information composed of user information and user control information into a 64B/66B customer information code block; encode configured overhead information into a 64B/66B code block, and mark the code block as an overhead code block; send the customer information code block and the overhead code block to a receiving device, where M of every N sent code blocks are overhead code blocks (M and N are positive integers and M is smaller than N); and
a receiving device, adapted to: receive the 64B/66B code block from the sending device; identify the overhead code block according to the identifier of the overhead code block and extract the overhead information from the overhead code block; and decode the customer information code blocks other than the overhead code blocks and obtain the customer information.

An overhead information sending device includes:
an overhead coding unit, adapted to: encode the configured overhead information into a 64B/66B code block, mark the code block as an overhead code block, and send the overhead code block to the sending unit;
a customer information coding unit, adapted to: encode the received customer information composed of user information and user control information into a 64B/66B customer information code block, and send the customer information code block to a sending unit; and
a sending unit, adapted to: receive the overhead code blocks of the overhead coding unit and the customer information code blocks of the customer information coding unit, and send the code blocks out, where M of every N sent 64B/66B code blocks are overhead code blocks (M and N are positive integers and M is smaller than N).

An overhead information receiving device includes:
a receiving unit, adapted to: receive a 64B/66B code block, and send the received code block to a code block type identifying unit;
a code block type identifying unit, adapted to: identify an overhead code block according to the identifier of the overhead code block, send the identified overhead code block to the overhead information extracting unit, and send customer information code blocks to the customer information decoding unit;
an overhead information extracting unit, adapted to: receive the overhead code block from the code block type identifying unit, and extract the overhead information from the overhead code block; and
a customer information decoding unit, adapted to decode the customer information code block received from the code block type identifying unit.

An overhead information transmission device includes:
a sending module, adapted to: encode the customer information composed of user information and user control information into a 64B/66B customer information code block; encode configured overhead information into a 64B/66B code block, and mark the code block as an overhead code block; send out the customer information code block and the overhead code block, where M of every N sent 64B/66B code blocks are overhead code blocks (M and N are positive integers and M is smaller than N); and
a receiving device, adapted to: receive the external 64B/66B code block; identify the overhead code block according to the identifier of the overhead code block and extract the overhead information from the overhead code block; and decode the customer information code blocks other than the overhead code blocks and obtain the customer information.

It can be seen from the above technical solution that, in the embodiments of the present invention, the configured overhead information is encoded into a 64B/66B code block, and the code block is marked as an overhead code block, at the time of sending overhead information. Through this marking mode, the receiver can identify the overhead code block in the code stream after receiving the code block, the overhead code blocks are sent together with the 64B/66B code blocks which carry customer information, and it is sure that one of every N code blocks is an overhead code block. At the time of receiving overhead information, the overhead code blocks are identified according to the identifier of the overhead code block in the received code stream, and the overhead information is extracted. The customer information code blocks are decoded based on the 64B/66B, and the customer information is transmitted to the application layer for resolving.

In the embodiments of the present invention, the capability of transferring the overhead information (including OAM information) is provided by inserting overhead blocks fixedly. By multiplexing the data and inserted overhead information (including OAM information) periodically, the insertion of the OAM information on the physical layer is certain. Therefore, the data or OAM information is identifiable on the physical layer through the timing relation, certain time and location relations can be obtained, and stable bandwidth of the overhead code blocks (including OAM information) is ensured. Moreover, because the size of the overhead code blocks is fixed, the performance detection function which needs measuring of the information with a fixed length can also be performed normally, and the detection performance enabled by OAM information is not restricted. In a word, the transmission performance of the OAM information is improved. Because the lowest-layer code block carries the overhead information, the link detection data on the physical layer can be extracted without participation of the customer layer.

Furthermore, the value of N is flexibly adjustable so that the bandwidth occupied by the OAM information can be adjusted conveniently.

### BRIEF DESCRIPTION OF THE DRAWINGS

Figure 1 shows a 64B/66B code block;

Figure 2 shows a coding mode of the 64B/66B applied in the 10G Ethernet in the prior art;

Figure 3 shows how an Ethernet packet header carries OAM information in the prior art;

Figure 4 shows how to use the Ethernet Inter-Frame Gap (IFG) to carry OAM information in the prior art;

Figure 5 is a general flowchart of a method for sending overhead information according to an embodiment of the present invention;

Figure 6 is a general flowchart of a method for receiving overhead information according to an embodiment of the present invention;

Figure 7 is a flowchart of a method for sending overhead information according to a first embodiment of the present invention;

Figure 8 is a flowchart of a method for receiving overhead information according to the first embodiment of the present invention;

Figure 9 shows a structure of an overhead information transmission system according to the first embodiment of the present invention;

Figure 10 is a flowchart of a method for sending overhead information according to a third embodiment of the present invention; and

Figure 11 is a flowchart of a method for receiving overhead information according to the third embodiment of the present invention.

### DETAILED DESCRIPTION

In order to make the technical solution, objectives and merits of the present invention clearer, a detailed description of the present invention is given below with reference to accompanying drawings and preferred embodiments.

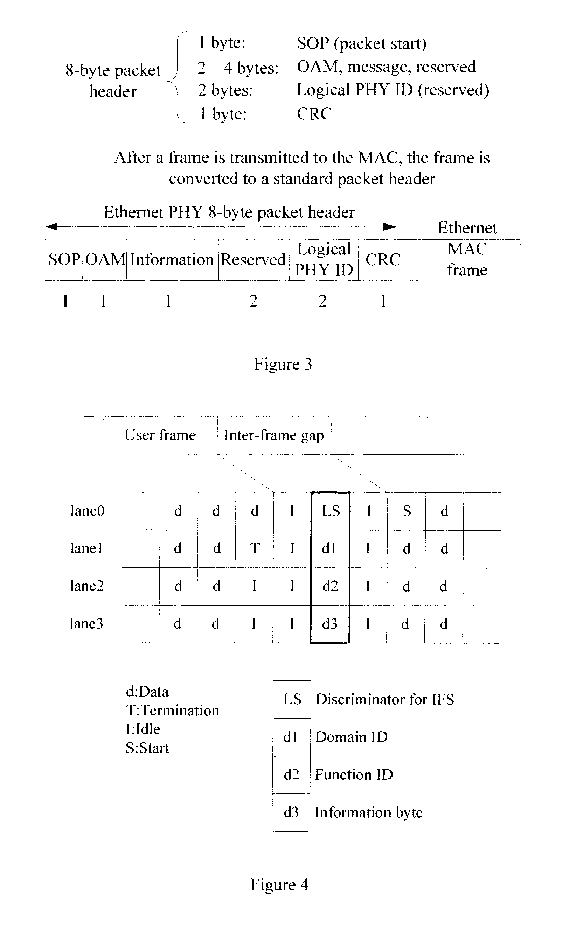

Currently, OAM information is inserted into a high-speed data transmission system in three modes. Through thorough research, the inventor finds the following defects of the three modes:
Mode 1: A solution similar to the SDH is applied, the fixed overhead information is inserted into the transmission information with a fixed length, and the inserted overhead information is differentiated through the reserved 10B control code. However, the OAM information is carried in the modes based on the 8B/10B coding mechanism. Therefore, 10 bits are consumed for transferring every 8 bits of user data. Consequently, the coding efficiency is reduced and the bandwidth waste radio is up to 20%.
Mode 2: Some fields in the preamble of the Ethernet frame are changed to make the fields carry OAM information. As shown in Figure 3, a byte after the SOP field carries the OAM information. After the OAM information is carried in such a way, the length of the Ethernet frame is variable between 64 bytes and 1518 bytes, namely, the length is random, and the data is also random because the Ethernet technology itself is based on statistic time division multiplexing. Therefore, if the Ethernet frame carries OAM information, the bandwidth of the OAM information is uncertain and jitters within a large range, and the OAM performance measurement is vulnerable to errors, which makes it impossible to obtain accurate evaluation and makes it difficult to implement simple error monitoring. For the performance detection function which requires measuring of the information with a fixed length, the function is impracticable if this mode is applied. Moreover, the OAM information is carried in the Ethernet frame rather than the code block. In order to resolve the OAM information which reflects the physical layer performance, the customer layer needs to perform detection, thus leading to delay of performance detection.
Mode 3: Part of the IFG (also known as Inter-Packet Gap, IPG) of the Ethernet frames carries the OAM information. As shown in Figure 4, LS, d1, d2, and d3 are the fields for carrying the OAM information. If the OAM information is carried in this mode, the problems involved in the second mode also exist, namely, the length of the Ethernet frame varies, which makes the OAM information bandwidth instable. Moreover, some performance detection functions are impossible, and the detection functions implemented by the OAM information are restricted.

Besides, under the Ethernet asynchronous communication technology based on the statistic time division multiplexing, if the IFG or preamble is used as a substitute to transmit OAM information, especially, if the IFG is used as a substitute, the transmitted OAM information inherits the randomness of arrival of Ethernet frames. As a result, the insertion of OAM information on the physical layer is random, no certain timing or location relation exists between customer data, and the data and OAM information cannot be differentiated through the timing relation on the physical layer. Therefore, neither mode 2 nor mode 3 supports the OAM functions which require a timing relation between the OAM and the customer data.

In view of the foregoing problems, the embodiments of the present invention provide a method, system and device for transmitting overhead information.

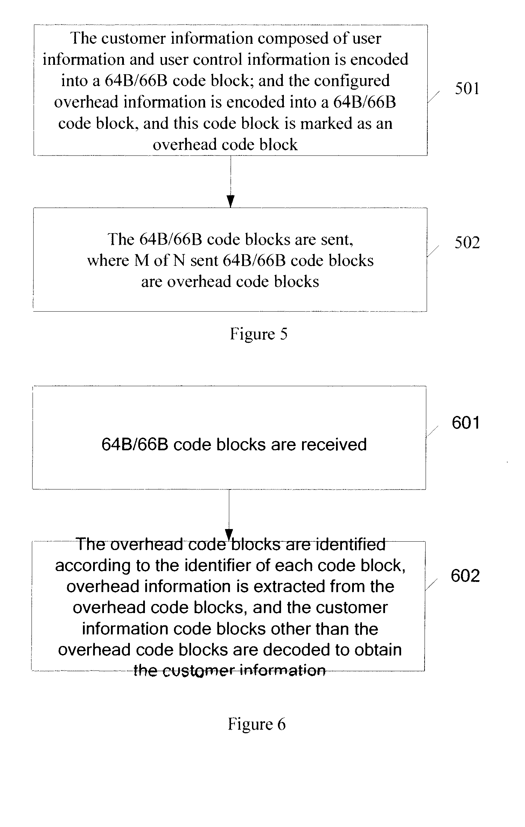

Figure 5 is a general flowchart of a method for sending overhead information according to an embodiment of the present invention. As shown in Figure 5, the method includes:

Step 501: The customer information composed of user information and user control information is encoded into a 64B/66B code block. The configured overhead information is encoded into a 64B/66B code block, and this code block is marked as an overhead code block.

Step 502: The 64B/66B code blocks are sent, where M of N 64B/66B code blocks sent are overhead code blocks.

In this step, M and N are positive integers, and M is smaller than N.

Accordingly, Figure 6 is a general flowchart of a method for receiving overhead information according to an embodiment of the present invention. As shown in Figure 6, the method includes:

Step 601: The 64B/66B code blocks are received.

Step 602: The overhead code blocks are identified according to the identifier of each overhead code block, overhead information is extracted from the overhead code blocks, and the customer information code blocks other than the overhead code blocks are decoded to obtain the customer information.

In the foregoing method for sending overhead information, the code blocks that carry the overhead information (namely, overhead code blocks) are marked in different modes: marking the overhead code blocks through a specified field, marking the overhead code blocks through integrity processing for the overhead information in the overhead code blocks, and marking the overhead code blocks through the location of each overhead code block in the code stream. Accordingly, the received overhead information is identified according to the specific identification mode of each overhead code block: identifying the overhead code block according to the contents of the specified field in the overhead code block, identifying the overhead code block by checking integrity of the information in the code block, and identifying the overhead code block according to the location of the overhead code block in the code stream.

Through the foregoing method for sending and receiving overhead information, the overhead information may be carried in the code blocks. The carried overhead information includes OAM information. In this way, a stable bandwidth utilization ratio of the OAM information is ensured, and the OAM information is obtained to implement performance detection of the physical-layer link without participation of the customer layer.

Embodiments of the present invention are elaborated below, where different identification modes are applied.

### Embodiment 1

In this embodiment, an overhead code block is marked through a specified field in the code block.

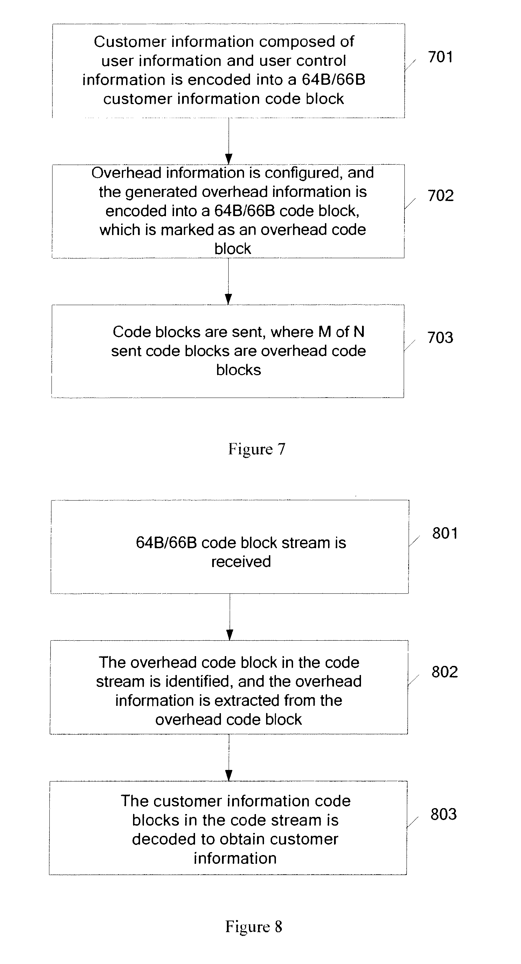

Figure 7 is a flowchart of a method for sending overhead information according to the first embodiment of the present invention. As shown in Figure 7, the method includes:

Step 701: The customer information composed of user information and user control information are encoded into a 64B/66B code block, which is called "customer information code block".

In this step, the mode of encoding the customer information into a code block is the same as the 64B/66B coding mode in the prior art.

Step 702: Overhead information is configured, and the generated overhead information is encoded to a 64B/66B code block, which is marked as an overhead code block.

In this step, the overhead code block is in a control block format, and a specified field in the control block format is used to mark the overhead code block. In this embodiment, a value of the specified block type field is used to indicate the overhead code block, for example, the value of the specified block type is 0x00 (Block Type Field = 0x00). That is, in this embodiment, an overhead code block is marked by setting the block type field in the overhead code block to a specified value.

The specific overhead information is input to a location next to the block type field in the code block payload. There are a total of 56 bits for carrying overhead information. Table 1 shows the specific coding rules, which cover the overhead code blocks and customer information code blocks, with the block type field of the overhead code block being set to 0x00. Alternatively, another value may be selected to mark the overhead code block only if the selected value is different from the value of the block type field of the user information. The overhead code block may further include other information such as Error Check Code (ECC) of the overhead information.

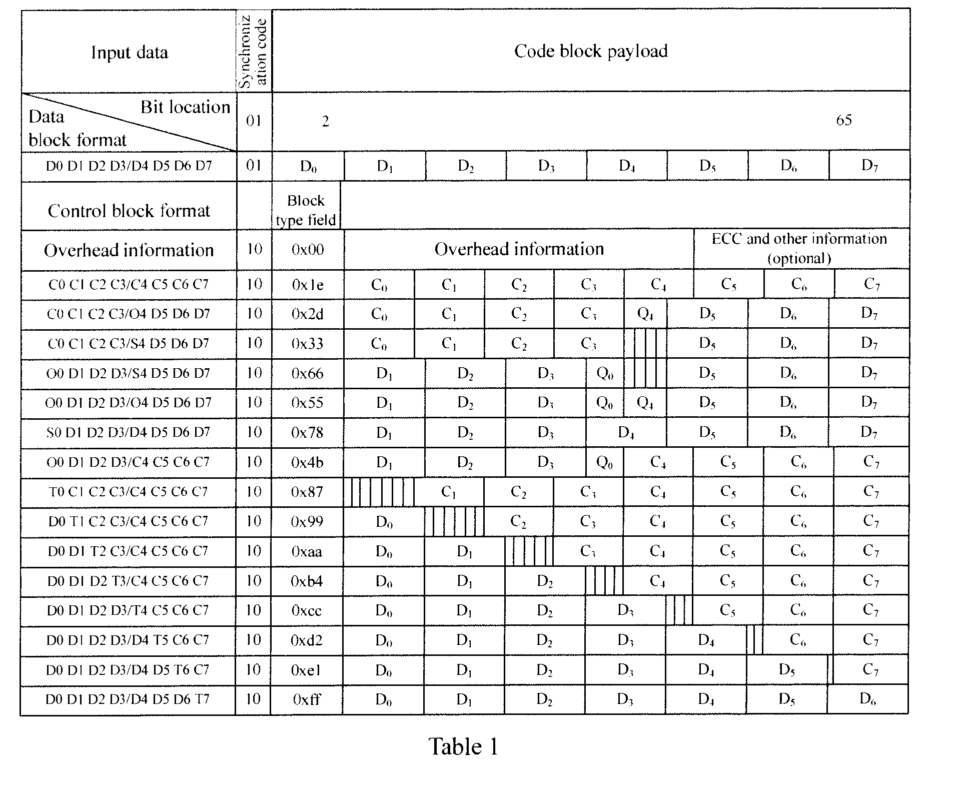

Step 703: The code blocks are sent, where M of every N sent code blocks are overhead code blocks, and M is smaller than N.

In this step, the values of M and N may be selected as required only if M is smaller than N. Because M of every N sent code blocks are overhead code blocks, the bandwidth occupied by the overhead code blocks is M/N. Once M and N are determined, the bandwidth occupied by the overhead information remains stable and unchanged. By adjusting M and N, the bandwidth occupied by the overhead code blocks may be adjusted conveniently.

Now the process of inserting overhead information in this embodiment ends. In the foregoing process, step 701 and step 702 are not sequence-sensitive. That is, step 702 may also be performed before step 701 or the two steps are performed concurrently.

In the foregoing step 702, if the overhead information block is marked through a specified field, the block is marked by specifying a value of the block type field. In this mode, there are a total of 56 bits for carrying overhead information. Because the check on the overhead information generally requires an additional error code, the available fields are relatively few. In order to improve the use efficiency, the block type field may be changed in this way: In the 8-bit block type field, the bit closest to the 2-bit synchronization code may be used to distinguish the overhead code block from the customer information code block. If this bit is 0, the block is an overhead code block; if this bit is 1, the block is a customer information code block. That is, the first bit of the block type field is used to mark the overhead information block. In this case, according to the 64B/66B coding rules in the prior art, the block type field of such customer information code blocks needs to be re-defined because the first bit in the block type field of some customer information code blocks is 0. For example, the coding format shown in Table 2 may apply.

Once the overhead code block is marked by the first bit in the block type field, all the 63 bits starting from the second bit in the block type field of the code block are used to carry overhead information. Therefore, more content information and ECCs may be carried.

Corresponding to the mode of sending overhead code blocks in this embodiment, Figure 8 shows a flowchart of the overhead information receiving method provided in this embodiment. As shown in Figure 8, the method includes:

Step 801: The 64B/66B code block streams are received.

Step 802: The overhead code block in the code stream is identified, and the overhead information is extracted from the overhead code block.

Corresponding to the mode of marking the overhead code block in step 702 in Figure 7, the mode of identifying the overhead code block in this step is: judging the value of the specified field indicative of the overhead code block in the code block; and, determining the code block as an overhead code block, if the value of the specified field in a code block is consistent with the value indicative of the overhead code block. The contents of the corresponding field in the code block may be extracted as overhead information.

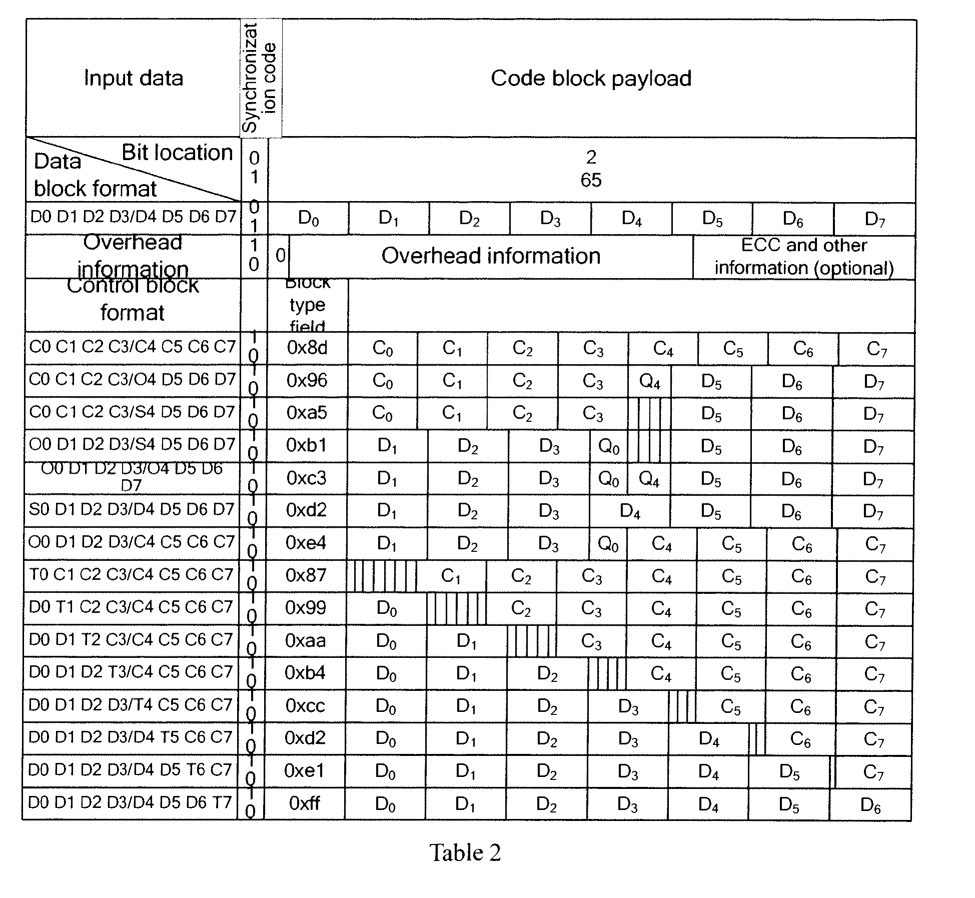

Specifically, if the mode of marking the overhead code block is that a specified field in the control block format whose synchronization code is 10 is used to mark the overhead code block, the mode of identifying the overhead code blocks in this step is: If the synchronization code is 10 (namely, the code block is in the control block format) and the value of the block type field is a specific value indicative of an overhead code block, the code block is determined as an overhead code block. For example, at the time of sending overhead information, if the block type field in the overhead code block is 0x00, the control code block with a block type field set to 0x00 in this step is determined as an overhead code block. The mode of extracting overhead information is: The contents carried in the 56 bits subsequent to the block type field are extracted as overhead information.

Alternatively, if the overhead code block is marked through a control block format with a synchronization code "10", and the "0" value of the first bit after the synchronization code represents overhead code blocks, the mode of identifying the overhead code block is: If the synchronization code is "10", and the first bit of the block type field is "0", the code block is determined as an overhead code block. In this case, the mode of extracting overhead information is: The contents carried in the 63 bits starting from the second bit of the block type field are extracted as overhead information.

If the overhead code block includes other information such as ECC, after the overhead information is extracted, the extracted overhead information may further undergo an error check to ensure reliability of the overhead information.

Step 803: The customer information code blocks in the code stream are decoded to obtain customer information.

Now the process of extracting overhead information ends. The extracted overhead information may be sent to the corresponding overhead function processing unit for processing, so as to know the performance information of the physical layer and implement performance statistics and fault notification of the physical layer. The decoded customer information may be sent to the upper-layer customer information processing unit for processing.

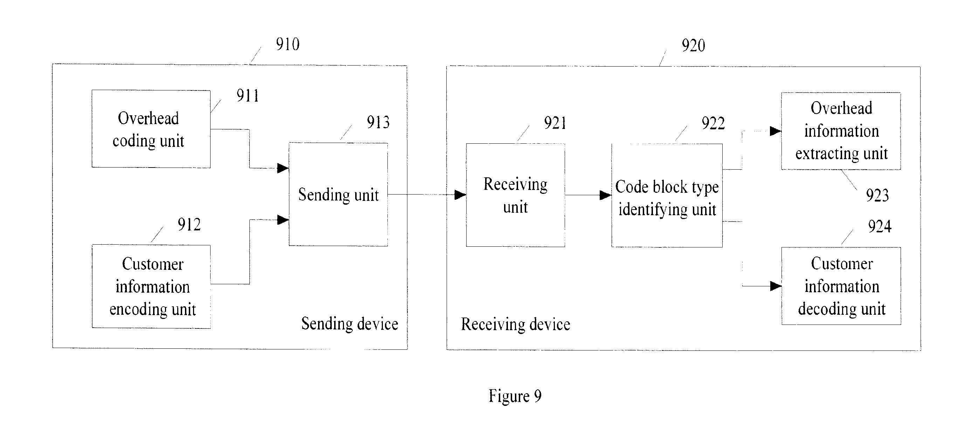

Figure 9 shows a structure of an overhead information transmission system according to the first embodiment of the present invention. As shown in Figure 9, the system includes a sending device 910 and a receiving device 920.

The sending device 910 represents the overhead information sending device provided in this embodiment.

The receiving device 920 represents the overhead information receiving device provided in this embodiment.

The sending device 910 includes: an overhead coding unit 911, a customer information coding unit 912, and a sending unit 913.

The receiving device 920 includes: a receiving unit 921, a code block type identifying unit 922, an overhead information extracting unit 923, and a customer information decoding unit 924.

In this system, the overhead coding unit 911 in the sending device 910 is adapted to: encode the configured overhead information into a 64B/66B code block, mark the code block as an overhead code block, and send the overhead code block to the sending unit 913.

The customer information coding unit 912 in the sending device 910 is adapted to: encode the received user information and user control information into a 64B/66B code block which is called "customer information code block", and send the customer information code block to the sending unit 913.

The sending unit 913 in the sending device 910 is adapted to: receive the overhead code blocks of the overhead coding unit 911 and the customer information code blocks of the customer information coding unit 912, and send the code blocks to the receiving unit 921 in the receiving device 920, where M of every N sent 64B/66B code blocks are overhead code blocks (M and N are positive integers and M is smaller than N).

The receiving unit 921 in the receiving device 920 is adapted to: receive the 64B/66B code block sent by the sending unit 911 in the sending device 910, and send the received code block to the code block type identifying unit 922.

The code block type identifying unit 922 is adapted to: identify the overhead code block according to the identifier of the overhead code block, send the identified overhead code block to the overhead information extracting unit 923, and send customer information code blocks to the customer information decoding unit 924.

The overhead information extracting unit 923 is adapted to: receive the overhead code block from the code block type identifying unit 922, and extract the overhead information from the overhead code block.

The customer information decoding unit 924 is adapted to decode the customer information code block received from the code block type identifying unit 922.

In the foregoing overhead information transmission system, the sending device may generate an overhead code block, insert the overhead code block into the 64B/66B code stream, and send it to the receiving device through the network. The receiving device identifies the overhead code block in the corresponding mode, and extracts the overhead information. In the overhead information transmission system, device B in the system performs the function of receiving the overhead information once a device at any side of the system sends or receives the overhead information. For example, device A in the system performs the function of sending the overhead information. In this way, the transmission of the generated overhead information in the transmission system is unidirectional. That is, the transmission is from device A to device B.

After the device at either side in the system incorporates the function of the peer, the function of sending and receiving overhead information can be performed between both sides of the system. For example, device A may send overhead information to device B, and may also receive overhead information from device B and extract the overhead information. Likewise, device B may receive overhead information from device A and extract the overhead information, and may also send overhead information to device A.

The overhead information transmission device for implementing the foregoing function is also provided in this embodiment. The device includes a sending module and a receiving module, and implements both sending and receiving of overhead information.

In this device, the sending module is adapted to: encode the customer information composed of user information and user control information into a 64B/66B customer information code block; encode configured overhead information into a 64B/66B code block, and mark the code block as an overhead code block; and send out the customer information code block and the overhead code block, where M of every N sent 64B/66B code blocks are overhead code blocks (M and N are positive integers and M is smaller than N).

The receiving device is adapted to: receive the external 64B/66B code block; identify the overhead code block according to the identifier of the overhead code block and extract the overhead information from the overhead code block; and decode the customer information code blocks other than the overhead code blocks and obtain the customer information.

Specifically, the structures of the sending module and receiving module are the same as the internal structures of the sending module and receiving module in the foregoing transmission overhead information system except this difference:

The sending unit in the sending module sends the generated customer information code blocks and overhead code blocks to the outside, whereas the receiving unit in the receiving module receives customer information code blocks and overhead code blocks from the outside, as not detailed here any further.

After the foregoing transmission overhead information devices constitute the devices at both sides, the overhead information in the system can be transmitted in both directions.

### Embodiment 2:

In this embodiment, an overhead code block is marked through integrity processing in the overhead code block.

The operation procedure in this embodiment is the same as the operation procedure shown in Figure 2 except that the coding mode of the overhead information and the mode of marking the overhead code block in step 702 are different. Specifically, in the overhead coding block, integrity processing is performed for the contents in the coding block through an integrity algorithm. The integrity algorithm may be a 16-bit Cyclic Parity Check (CRC16) algorithm. The contents processed through the integrity algorithm may be the whole 66-bit code block or the 64-bit data subsequent to the synchronization code.

Table 3 shows the coding rules in this embodiment. As shown in Table 3, the synchronization code of the overhead code block is "10" in order to reduce the probability of algorithm conflict. The overhead information and other optional information occupy 48 bits, and the remaining 16 bits are calculated out according to the CRC 16 algorithm. The data in other code blocks is random, and the probability that the data exactly meets the integrity processing requirement is very low.

Nevertheless, the value of the synchronization code in the overhead code block may also be the same as the value of the data code block, namely, "01". The value of the code block payload in the data code block is completely random, the probability of meeting the integrity algorithm is high, and the transmission amount of the data code block is huge, so the aggregate which meets the integrity algorithm is greater. Therefore, it is not recommended to set the synchronization code of the overhead code block to "01".

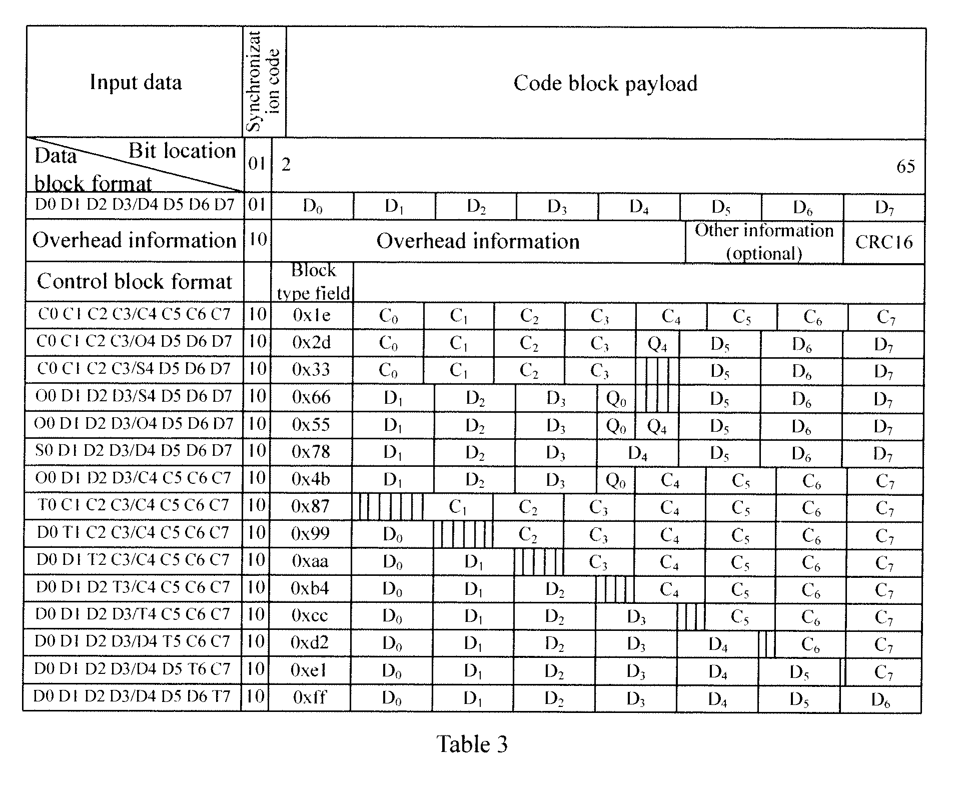

Described above is a method for inserting overhead information in this embodiment. Corresponding to the above method embodiment, the general operation procedure in the case of extracting overhead information is the same as the operation procedure shown in Figure 8 except that the mode of identifying the overhead code block is different. Specifically, if the received 64B/66B code block completely complies with the integrity algorithm, this code block is determined as an overhead code block.

In the foregoing mode, the mode of encoding the customer information code block is not changed. In order to further reduce the probability of conflict, two values may be defined for each block type. If the combination of the block type selected first and the subsequent user information meets the integrity algorithm exactly, the second block type may be selected.

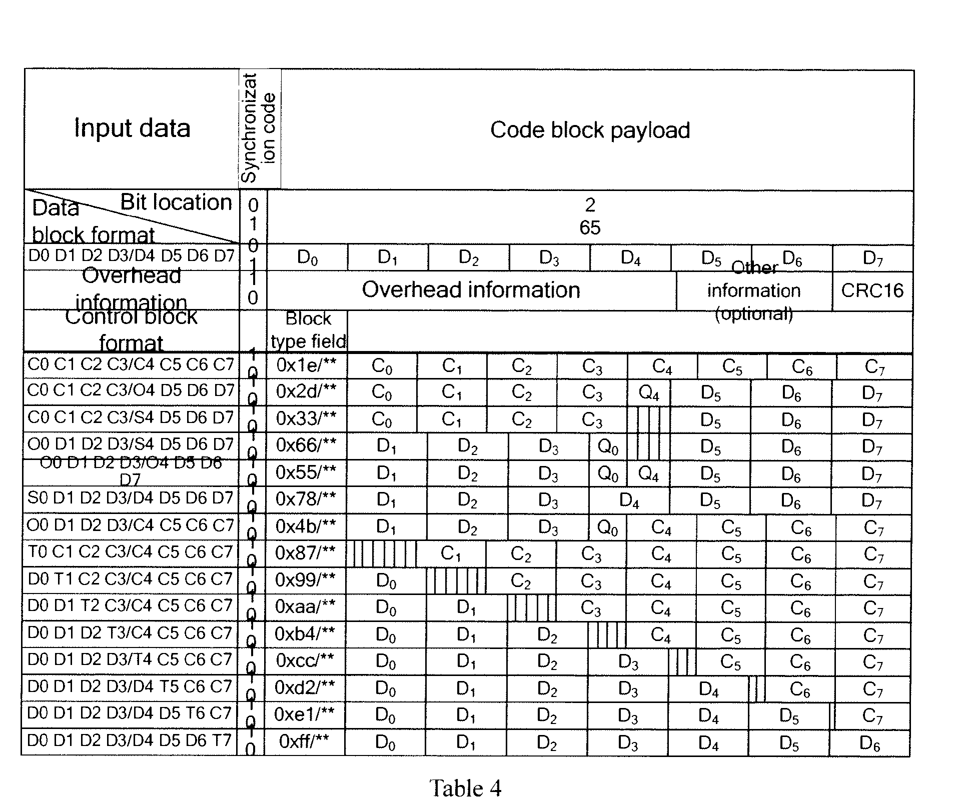

Correspondingly, the receiver identifies the overhead code block still by checking whether the code block complies with the integrity algorithm, and the code block which complies with the integrity algorithm is an overhead code block. The user information is decoded according to the rules about the block type field in Table 4.

The system, sending device, receiving device, and overhead information transmission device in the first embodiment are also applicable to the overhead information transmission system for implementing the method in the second embodiment.

As regards the coding mode of code blocks in this embodiment, because integrity check is added, the transmission reliability of the overhead code block is ensured, and the link performance and fault indication reflected by the overhead code block is more credible.

### Embodiment 3

In this embodiment, an overhead code block is marked through the location of the overhead code block in the code stream.

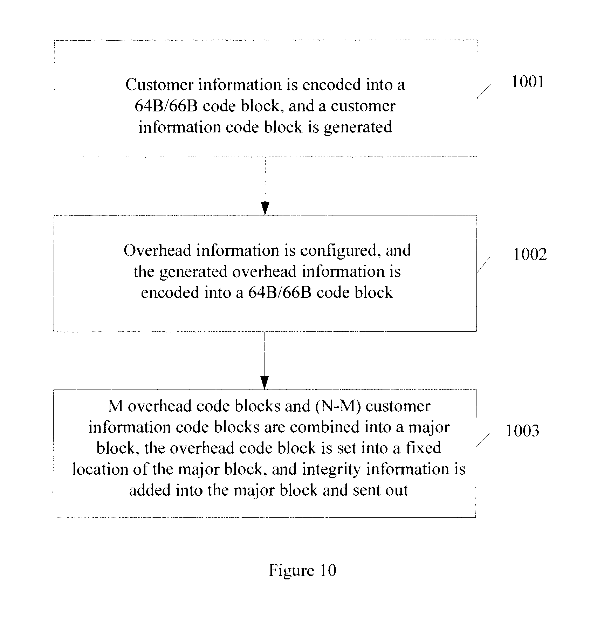

Figure 10 is a flowchart of a method for sending overhead information according to the third embodiment of the present invention. As shown in Figure 10, the method includes:

Step 1001: Customer information is encoded into a 64B/66B code block, and a customer information code block is generated.

Step 1002: Overhead information is configured, and the generated overhead information is encoded into a 64B/66B code block.

In this step, the overhead code block does not necessarily have a synchronization code, and all 66 bits are used to indicate the overhead information. If permitted, a check bit and other information may be added.

Step 1003: M overhead code blocks and (N-M) customer information code blocks are combined into a major block, the overhead code block is set into a fixed location of the major block, and integrity information is added into the major block and sending it out.

In this step, the overhead code block is identified in this way: M overhead code blocks and (N-M) customer information code blocks are combined into a major block, and the overhead code block is identified through the fixed location in the major block, where M and N are positive integers and M is smaller than N. That is, the overhead code block is always in the fixed location in the major block, and may be the first, intermediate, or last code block.

The integrity information added into the major block may be Forward Error Correction (FEC) information. Meanwhile, depending on the specific integrity algorithm, the calculated integrity information may be distributed in the whole major block, or appended as a whole to the major block.

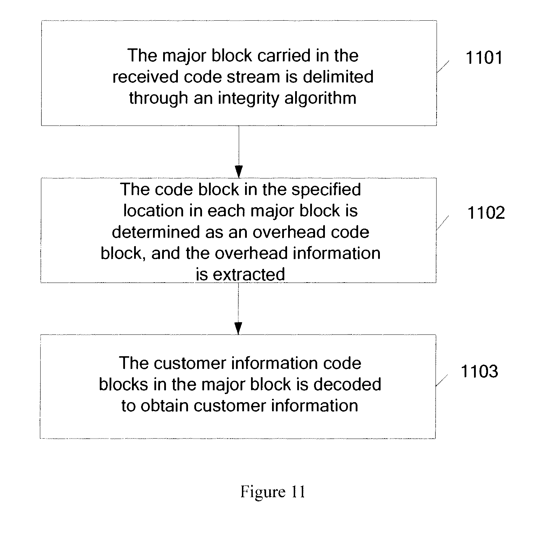

Now the process of inserting overhead information in this embodiment ends. Step 1001 and step 1002 may be performed concurrently, or step 1002 is performed before step 1001. Corresponding to the method for sending overhead information in Figure 10, the method for receiving the overhead information at the receiver is shown in Figure 11. The method includes:

Step 1101: The major block carried in the received code stream is delimited through an integrity algorithm.

Step 1102: The code block in the specified location in each major block is determined as an overhead code block, and the overhead information is extracted.

Corresponding to the mode of marking the overhead code block in Figure 10, the mode of identifying the overhead code block in this step is: determining the code block in the corresponding location in the major block as an overhead code block. The information in this code block is extracted as overhead information.

Step 1103: Other code blocks in the major block are decoded to obtain customer information.

Now the process of extracting overhead information in this embodiment ends. Step 1102 and step 1103 may be performed concurrently, or step 1103 is performed before step 1102.

Through the method in this embodiment, an overhead code block may use all the 66 bits to carry overhead information so that more overhead information contents can be carried in a code block. By adding check information into the overhead code block, the transmission reliability of overhead information is further ensured. Likewise, the method in this embodiment may be implemented in the overhead information transmission system and overhead information transmission device in the first embodiment.

Through the foregoing description about the method, system and device for transmitting overhead information in the embodiments of the present invention, it can be seen that: Because the data and inserted overhead information (including OAM information) are multiplexed periodically, the data or OAM information is surely identifiable on the physical layer through the timing relation, and certain time and location relations can be obtained. Moreover, stable bandwidth of the overhead code block (including OAM information) is ensured, and the performance detection function which needs measuring of the information with a fixed length can also be performed normally, and the detection performance enabled by OAM information is not restricted. In a word, the transmission performance of the OAM information is improved.

Although the invention has been described through several preferred embodiments, the invention is not limited to such embodiments. It is apparent that those skilled in the art can make various modifications and variations to the invention without departing from the spirit and scope of the invention. The invention is intended to cover the modifications and variations provided that they fall in the scope of protection defined by the following claims or their equivalents.

## Claims

1. A method for sending overhead information, comprising:
encoding customer information composed of user information and user control information into a 64B/66B customer information code block;
encoding configured overhead information into a 64B/66B code block, and marking the code block as an overhead code block; and
sending the customer information code block and the overhead code block, wherein M of every N sent code blocks are overhead code blocks (M and N are positive integers and M is smaller than N).

2. The method of claim 1, wherein the marking the code block as the overhead code block comprises:
using a specified field in the code block to mark the overhead code block.

3. The method of claim 2, wherein: the encoding the configured overhead information into the 64B/66B code block comprises: encoding the overhead information according to a 64B/66B control block format, and using 56 bits subsequent to a block type field to carry the overhead information; and
the using the specified field in the code block to mark the overhead code block comprises: using a specified value of the block type field to mark the overhead code block.

4. The method of claim 2, wherein:
the encoding the configured overhead information into the 64B/66B code block comprises: encoding the overhead information according to the 64B/66B control block format, and using 63 bits subsequent to a first bit in the block type field to carry the overhead information;
the using the specified field in the code block to mark the overhead code block comprises: using a specified value of the first bit in the block type field to mark the overhead code block; and
the method further comprises:
using the value of the first bit in the block type field to mark the customer information code block encoded in the control block format.

5. The method of claim 3 or claim 4, wherein an Error Check Code, ECC, is further carried at the time of carrying the overhead information.

6. The method of claim 1, wherein the marking the code block as the overhead code block comprises:
carrying, by the overhead code block, integrity information obtained after content information undergoes integrity processing through an integrity algorithm.

7. The method of claim 6, wherein the content information is:
content of 66 bits in the overhead code block, or content of 64 bits subsequent to a synchronization code in the overhead code block.

8. The method of claim 6 or claim 7, wherein:
the encoding the configured overhead information into the 64B/66B code block iscomprises: encoding the overhead information according to the 64B/66B control block format, and using a field between the synchronization code and the integrity information to carry the overhead information; and
the method further comprises:
setting two types of values for all block type fields encoded in the control block format, and encoding the customer information code block through another value of the block type field when the customer information code block encoded in the control block format complies with the integrity algorithm.

9. The method of claim 1, wherein:
the method further comprises: combining M overhead code blocks and N-M customer information code blocks into a major block after the configured overhead information is encoded into the 64B/66B code block, and using the integrity algorithm to perform integrity processing for the major block and obtain integrity information;
the marking the code block as the overhead code block comprises: using a specified location in the major block to mark the overhead code block;
the sending the customer information code block and the overhead code block (M of every N sent 64B/66B code blocks are overhead code blocks) comprises: sending the major block and the integrity information of the major block; and
the integrity information is located in the major block or appended to the major block.

10. The method of claim 1, wherein, the step of sending the customer information code block and the overhead code block, wherein M of every N sent code blocks are overhead code blocks further comprises: locations of the M overhead code blocks in the N sent code blocks remain fixed and unchanged.

11. A method for receiving overhead information, comprising:
receiving 64B/66B code blocks;
identifying an overhead code block according to an identifier of a code block, and extracting overhead information from the overhead code block; and
decoding customer information code blocks other than the overhead code block to obtain customer information.

12. The method of claim 11, wherein the identifying the overhead code block according to the identifier of the code block comprises:
identifying the overhead code block according to a specified field in the code block.

13. The method of claim 12, wherein:
the specified field is a specified value of a block type field; and
the extracting the overhead information comprises: extracting information carried in 56 bits subsequent to the block type field in the overhead code block.

14. The method of claim 12, wherein:
the specified field is a specified value of a first bit in the block type field; and
the extracting the overhead information comprises: extracting information carried in 63 bits subsequent to the first bit in the block type field of the overhead code block.

15. The method of claim 13 or claim 14, wherein if an Error Check Code, ECC, is carried in the overhead code block, the method further comprises:
performing error check for the extracted overhead information.

16. The method of claim 11, wherein identifying the overhead code block according to the identifier of the code block is:
using an integrity algorithm to perform integrity check for the received code block, and determining the code block which complies with the integrity check as an overhead code block.

17. The method of claim 11, wherein:
the receiving the 64B/66B code blocks comprisesis: receiving a major block composed of M overhead code blocks and N-M customer information code blocks as well as integrity information of the major block, and using the integrity algorithm to delimit the major block; and
the identifying the overhead code block according to the identifier of the code block comprisesis: determining the code block in a specified location in the major block as an overhead code block.

18. An overhead information transmission system, comprising:
a sending device, adapted to: encode customer information composed of user information and user control information into a 64B/66B customer information code block; encode configured overhead information into a 64B/66B code block, and mark the code block as an overhead code block; send the customer information code block and the overhead code block to a receiving device, wherein M of every N sent code blocks are overhead code blocks (M and N are positive integers and M is smaller than N); and
a receiving device, adapted to: receive the 64B/66B code block from the sending device; identify the overhead code block according to an identifier of the overhead code block and extract overhead information from the overhead code block; and decode the customer information code blocks other than the overhead code blocks to obtain the customer information.

19. An overhead information sending device, comprising:
an overhead coding unit, adapted to: encode configured overhead information into a 64B/66B code block, mark the code block as an overhead code block, and send the overhead code block to a sending unit;
a customer information coding unit, adapted to: encode received customer information composed of user information and user control information into a 64B/66B customer information code block, and send the customer information code block to the sending unit; and
the sending unit, adapted to: receive overhead code blocks of the overhead coding unit and customer information code blocks of the customer information coding unit, and send the code blocks out, wherein M of every N sent 64B/66B code blocks are overhead code blocks (M and N are positive integers and M is smaller than N).

20. The device of claim 19, wherein M of every N sent code blocks are overhead code blocks in addition to:
locations of the M overhead code blocks in the N sent code blocks remain fixed and unchanged.

21. An overhead information receiving device, comprising:
a receiving unit, adapted to: receive a 64B/66B code block, and send the received code block to a code block type identifying unit;
the code block type identifying unit, adapted to: identify an overhead code block according to an identifier of the overhead code block, send the identified overhead code block to an overhead information extracting unit, and send customer information code blocks to a customer information decoding unit;
the overhead information extracting unit, adapted to: receive the overhead code block from the code block type identifying unit, and extract overhead information from the overhead code block; and
the customer information decoding unit, adapted to decode the customer information code block received from the code block type identifying unit.

22. An overhead information transmission device, comprising:
a sending module, adapted to: encode customer information composed of user information and user control information into a 64B/66B customer information code block; encode configured overhead information into a 64B/66B code block, and mark the code block as an overhead code block; send out the customer information code block and the overhead code block, wherein M of every N sent 64B/66B code blocks are overhead code blocks (M and N are positive integers and M is less than N); and
a receiving device, adapted to: receive an external 64B/66B code block; identify the overhead code block according to an identifier of the overhead code block and extract overhead information from the overhead code block; and decode customer information code blocks other than the overhead code blocks to obtain the customer information.

23. The device of claim 22, wherein M of every N sent code blocks are overhead code blocks in addition to:
locations of the M overhead code blocks in the N sent code blocks remain fixed and unchanged.
